# EUROPEAN PATENT APPLICATION

(11) **EP 3 444 949 A1**
(43) Date of publication of application: **20.02.2019**
(21) Application number: 17186788.0
(22) Date of filing: 18.08.2017
(51) Int. Cl.: H03K 17/081, H03K 17/10, H02M 1/32

(54) **INVERTER**

(71) Applicant: Siemens Aktiengesellschaft, 80333 München (DE)
(72) Inventor: Carter, Robert, Knutsford, WA16 8XU (GB)
(74) Representative: Maier, Daniel Oliver

(57) **Abstract**

An inverter comprising: an upper switching circuit provided between an input rail and a halfway node, that respectively serve as the high voltage and low voltage rails for the upper switching circuit; and a lower switching circuit provided between the halfway node and an output voltage rail, that respectively serve as the high voltage and low voltage rails for the lower switching circuit. At least one of the upper and lower switching circuits comprises a first transistor and a second transistor. A bias voltage is provided at the source-drain connection of second and first transistors in at least one of the upper and lower switching circuits.

## Description

### Field of the Invention

The present disclosure relates to inverters.

### Background

High-electron-mobility transistors (HEMTs) can operate at high frequency and with relatively low switching losses when compared to silicon or silicon carbide field effect devices. HEMTs fabricated from gallium nitride, with operating voltages of 600V are commercially available, including those that operate in enhancement mode, i.e. normally off. These devices are of particular interest in inverter applications due to the ease of integration with existing standard driver arrangements. However, for high power and high frequency operation, the limitation in operating voltage and the impact of relatively high device parasitic capacitance means the general advantages of these devices are hard to realise.

Hence a simple inverter circuit which is able to operate at high power and high frequency using HEMTs is highly desirable, in particular one which maintains the ability to use standard driver arrangements and which has straightforward initialisation procedures before switching starts.

### Summary

Accordingly, there is provided a switching circuit as set forth in the appended claims. Other features of the invention will be apparent from the dependent claims, and the description which follows.

In one example there is provided an inverter comprising:
an upper switching circuit provided between an input rail and a halfway node, that respectively serve as the high voltage and low voltage rails for the upper switching circuit;
a lower switching circuit provided between the halfway node and an output rail that respectively serve as the high voltage and low voltage rails for the lower switching circuit; and
a dc capacitor bank connected between the input rail and the output rail and arranged to divide the voltage difference between the input rail and the output rail such that, in use, operation of the upper and lower switching circuits provides an output voltage between the halfway node and the divided voltage at the midpoint node of the dc capacitor bank; wherein
at least one of the upper and lower switching circuits comprises a first transistor and a second transistor, the first transistor comprising:
   a gate, a source and a drain, the gate being operatively coupled to a drive circuit to control switching operation of the switching circuit,
   the second transistor comprising:
      a gate, a source and a drain, the source being connected to the drain of the first transistor, the gate being coupled to the source of the first transistor, and the drain being connected to the high voltage rail; and wherein
      a bias voltage is provided at the source-drain connection of the second transistor and the first transistor at the halfway node in said switching circuit, such that when the switching circuit is in the off state the first transistor is subjected to a drain source voltage corresponding to the difference between the bias voltage and the voltage of the low voltage rail, and the second transistor is subjected to a drain source voltage corresponding to the difference between the voltage of the high voltage rail and the bias voltage.

By using a bias voltage between the first and second transistors, the voltage blocking capability of the switching circuit is increased above that of the individual transistors separately. In this way the switching circuit can operate at higher voltage, and therefore is more suited to higher power applications.

In one example each of the upper and lower switching circuits comprises a first transistor and a second transistor, the first transistor comprising: a gate, a source and a drain, the gate being operatively coupled to a drive circuit to control switching operation of the switching circuit, the second transistor comprising: a gate, a source and a drain, the source being connected to the drain of the first transistor, the gate being coupled to the source of the first transistor, and the drain being connected to the high voltage rail; and wherein a bias voltage is provided at the source-drain connection of the second transistor and the first transistor at the halfway node in said switching circuit, such that when the switching circuit is in the off state the first transistor is subjected to a drain source voltage corresponding to the difference between the bias voltage and the voltage of the low voltage rail, and the second transistor is subjected to a drain source voltage corresponding to the difference between the voltage of the high voltage rail and the bias voltage.

In one example the bias voltage is provided from the dc capacitor bank.

In one example the bias voltage is provided from a midpoint node at a midpoint of the dc capacitor bank such that the midpoint node is in use clamped to half the voltage difference between the high voltage rail and the low voltage rail.

In one example the bias voltage is provided via a gate protection diode that is arranged between the gate and source of the second transistor. In one example the bias voltage is provided via a gate protection diode arranged between the gate and source of the second transistor, with the bias voltage comprising the voltage at the midpoint node less the diode voltage drop of the gate protection diode. In one example the gate protection diode is a zener diode.

By using a gate protection diode in this way the voltage difference between the halfway voltage and bias voltage is readily maintained at a level which does not significantly impact the division of the voltage blocking function of the two transistors when the switching circuit is in the off state, and the second transistor is protected from damage by overvoltage between its gate and its source.

In one example the inverter further comprises a bootstrap unit for at least one of the upper and lower switching circuits, the bootstrap unit arranged to stabilise the arrangement of the first and second transistors in the associated switching circuit in an initial off state before switching operation of the upper and lower switching circuits starts.

In one example the bootstrap unit is arranged to stabilise the arrangement of the first and second transistors in the associated switching circuit in an initial off state while the other switching circuit is driven in an initial on state before switching operation of the upper and lower switching circuits starts.

In one example the bootstrap unit comprises a capacitor arranged to stabilise the bias voltage between the source of the first transistor and the gate of the second transistor in the associated switching circuit.

In one example the bootstrap unit comprises a capacitor charged from the halfway node.

In one example the bootstrap unit is provided for the upper switching circuit.

In one example the upper and/or lower switching circuit(s) comprise(s) a capacitor arranged between the source of the first transistor and gate of the second transistor, the capacitance of which is matched to the parasitic capacitances in the switching circuit to speed up operation of the second transistor by delivering/receiving charge to/from the gate of the second transistor during switching of the second transistor.

In this way the operation of the first and second transistors can be matched so that good transient performance is achieved on switching.

In one example the upper and/or lower switching circuit(s) comprise(s) a first transistor and a second transistor which are nominally identical to one another, such as having the same electronic characteristics, e.g. comprising transistors of the same type/model. In one example the upper and/or lower switching circuit(s) comprise(s) a first transistor and a second transistor which are both normally-off HEMT devices. In one example the first transistor and/or second transistor comprises a HEMT transistor, such as a GaN transistor. In one example the second transistor comprises a HEMT transistor, such as a GaN transistor. In one example the first transistor comprises a normally off transistor. In one example the second transistor comprises a normally off transistor.

In this way the voltage blocking requirement for each transistor is minimised by being shared equally between the two, and the circuit design is simplified by use of matched components.

In one example the inverter comprises a two level half bridge inverter. In one example the inverter comprises a plurality of power switching circuits which are operated to generate the inverter output, and each power switching circuit comprises a switching circuit as described in the examples set out above. In one example the inverter comprises a two level inverter. In one example the inverter comprises a three phase inverter, with each phase comprising a leg including a switching circuit as described in the examples set out above. In one example the inverter comprises part of an ac drive, such as a motor drive.

### Brief Description of the Drawings

Examples of the present disclosure will now be described with reference to the accompanying drawings, in which:
Figure 1 shows a switching circuit for use in an inverter according to an example embodiment; and
Figure 2 shows a circuit comprising an inverter according to an example embodiment.

### Detailed Description

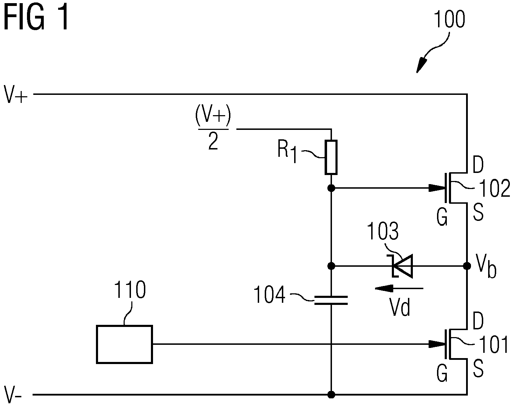

Figure 1 shows a switching circuit 100 for use in an inverter according to an example embodiment. The switching circuit comprises a first transistor 101 and a second transistor 102 that are cascoded with one another between high and low voltage rails V+, V-. The first transistor 101 comprises a gate, a source and a drain, the gate being operatively coupled to a drive circuit 110 to control switching operation of the switching circuit 100.

The second transistor 102 comprises a gate, a source and a drain, the source of the second transistor 102 being connected to the drain of the first transistor 101, and the gate of the second transistor 102 being coupled to the source of the first transistor 101 in a cascode arrangement between the low voltage rail V- at the source of the first transistor 101 and the high voltage rail V+ at the drain of the second transistor 102.

A bias voltage Vb is provided at the connection between the source of the second transistor 102 and the drain of the first transistor 101. In this way, when the switching circuit 100 is in the off state the first transistor 101 is subjected to a drain source voltage corresponding to the difference between the bias voltage Vb and the voltage of the low voltage rail V-. Similarly, the second transistor 102 is subjected to a drain source voltage corresponding to the difference between the voltage of the high voltage rail V+ and the bias voltage Vb.

In this way the voltage blocking capability of the switching circuit 100 is increased above that of the individual transistors 101, 102. For example, it would not be possible for a typical GaN HEMT with rated blocking voltage of 650V to operate as single switching device in a circuit with V+ at 800V and V- at neutral, as may be required in high power ac motor drives. However, in a switching circuit as above with Vb provided around 400V, switching between V+ at 800V and V- at neutral is possible without either 650V rated transistor being overloaded. In addition to the division of voltage blocking between the first and second transistors, the arrangement of the first and second transistors reduces the effective capacitance of the switching circuit in comparison to that of the separate transistor elements if used as a single switching device.

The bias voltage Vb is provided at the source-drain connection of second transistor 102 via a gate protection zener diode 103 that is arranged between the gate and source of the second transistor 102. A midpoint node maintained at halfway voltage (V+)/2, comprising the bias voltage Vb plus the diode voltage Vd, is provided, and described in more detail below in relation to Figure 3. The zener diode 103 maintains the bias voltage Vb and protects the gate of the second transistor from overvoltage damage, with pull-up resistor R1 provided between the halfway node and the gate of the second transistor 102. To prevent issues arising from charge storage at the gate of the second transistor 102 a schottky diode may be provided in parallel in some other embodiments.

In order to improve switching operation of the second transistor 102 a speedup capacitor 104 is provided between the source of the first transistor 101 and gate of the second transistor 102. When the gate of the first transistor 101 is driven by the drive circuit 110 to switch the first transistor 101, the cascode connection serves to swtich on the second transistor 102 to thereby connect the high and low voltage rails. The speedup capacitor 104 is matched to parasitic capacitances in the switching circuit, including the input capacitance of the second transistor 102 to speed up the switching operation of the second transistor 102 by delivering/receiving charge to/from the gate of the second transistor 102 during switching on/off operation of the second transistor 102. In this way the operation of the first and second transistors 101,102 can be matched so that good transient performance is achieved on switching.

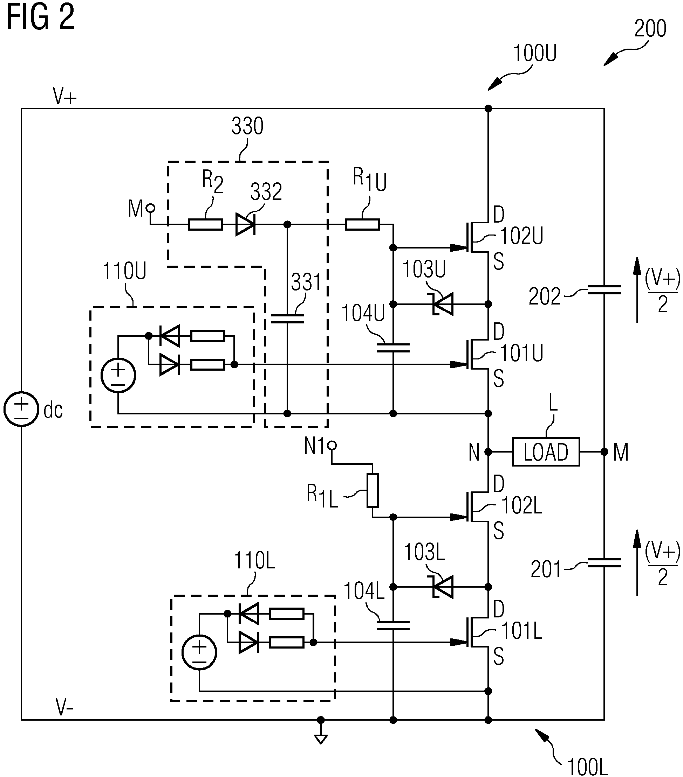

Figure 2 shows a circuit comprising an inverter 200 according to an example embodiment. The inverter 200 comprises two switching circuits 100U, 100L as described relation to the example embodiments set out above. The inverter is connected to a dc supply at V+, and delivers ±(V+)/2 to the load L which is connected between the halfway node N and the midpoint node M of a dc capacitor bank 202, 201, according to the switching operation of the switching circuits 100U, 100L. The inverter 200 operates as a half bridge and can be used as one leg of a three phase, two-level ac motor drive. The use of switching circuits 100U, 100L enables the inverter 200 to operate efficiently in terms of switching loss and high frequency performance as previously explained, and also enables the inverter 200 to operate with a low component count and with standard gate driver arrangements for the switching circuits, thereby reducing cost. As will be appreciated, providing the input dc as V+ with reference to ground, i.e. V- is 0V is a convenient arrangement, but is not essential. Similarly, although the first and second transistors in both upper and lower switching circuits are matched in terms of their electronic characteristics, and the dc capacitor bank evenly splits the dc voltage to provide the midpoint voltage M, these are design choices made for convenience in the example embodiments.

The upper switching circuit 100U is provided between an input rail V+ and a halfway node N, that respectively serve as the high voltage and low voltage rails for the upper switching circuit 100U. The inverter 200 further comprises a lower switching circuit 100L provided between the halfway node N and an output voltage rail V- that respectively serve as the high voltage and low voltage rails for the lower switching circuit 100L, the output voltage rail being grounded.

The bias voltage Vb provided at the source-drain connection of the second and first transistors in the upper switching circuit 100U, and in the lower switching circuit 100L are each provided from the halfway node N. In the example embodiment of Figure 3 the bias voltage Vb is equivalent to the voltage at the halfway node N, less the voltage drop across the gate protection zener diode in the respective second transistors 102U and 102L.

To facilitate reliable initialisation of the inverter 200, the upper switching circuit 100U comprises a bootstrap unit 330. The bootstrap unit 330 comprises a capacitor 331 that serves to stabilise the base voltage of the second transistor 102U in the upper switching circuit 100U, keeping the transistors of the upper switching circuit in an initial off state before switching operation of the upper and lower switching circuits 100U, 100L starts.

The lower switching circuit 100L is switched on first during initialisation, by operation of the lower gate driver circuit 110L energising the gate of the first transistor 101 L of the lower switching circuit 100L. The RC pair including resistor R2 and capacitor 331 of the bootstrap unit 330 is charged during this time, while the upper switching circuit 100U remains switched off. The bias voltage between the source of the second transistor 102U and the gate of the first transistor 101 U builds, and then switching operation can commence without interference from transients or instability as the upper and lower switching circuits 100U, 100L synchronise. The diode 332 in the bootstrap unit 330 isolates the capacitor 331 from the halfway node N in normal operation of the upper and lower drive, following initialisation.

As set out above, the switching circuit of example embodiments and inverters that include the same have a number of advantages, and are particularly suited to inclusion in ac motor drives that operate at higher power than can be readily achieved using currently available HEMTs.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An inverter (200) comprising:
an upper switching circuit (110U) provided between an input rail (V+) and a halfway node (N), that respectively serve as the high voltage and low voltage rails for the upper switching circuit (100U);
a lower switching circuit (100L) provided between the halfway node (N) and an output rail (V-) that respectively serve as the high voltage and low voltage rails for the lower switching circuit (100L); and
a dc capacitor bank (202, 201) connected between the input rail (V+) and the output rail (V-) and arranged to divide the voltage difference between the input rail (V+) and the output rail (V-) such that, in use, operation of the upper and lower switching circuits (110U, 110L) provides an output voltage between the halfway node (N) and the divided voltage at a midpoint node (M) of the dc capacitor bank (202, 201); wherein
at least one of the upper and lower switching circuits (100U, 100L) comprises a first transistor (101) and a second transistor (102), the first transistor (101) comprising:
a gate, a source and a drain, the gate being operatively coupled to a drive circuit (110) to control switching operation of the switching circuit (100U, 100L),
the second transistor (102) comprising:
a gate, a source and a drain, the source being connected to the drain of the first transistor (101), the gate being coupled to the source of the first transistor (101), and the drain being connected to the high voltage rail; and wherein
a bias voltage (Vb) is provided at the source-drain connection of the second transistor (102) and the first transistor (101) at the halfway node (N) in said switching circuit (110U, 110L), such that when the switching circuit (110U, 110L) is in the off state the first transistor (101) is subjected to a drain source voltage corresponding to the difference between the bias voltage (Vb) and the voltage of the low voltage rail (V-), and the second transistor (102) is subjected to a drain source voltage corresponding to the difference between the voltage of the high voltage rail (V+) and the bias voltage (Vb).

2. The inverter (200) of claim 1, wherein each of the upper and lower switching circuits (100U, 100L) comprises a first transistor (101) and a second transistor (102), the first transistor (101) comprising:
a gate, a source and a drain, the gate being operatively coupled to a drive circuit (110) to control switching operation of the switching circuit (100U, 100L),
the second transistor (102) comprising:
a gate, a source and a drain, the source being connected to the drain of the first transistor (101), the gate being coupled to the source of the first transistor (101), and the drain being connected to the high voltage rail; and wherein
a bias voltage (Vb) is provided at the source-drain connection of the second transistor (102) and the first transistor (101) at the halfway node (N) in said switching circuit (110U, 110L), such that when the switching circuit (110U, 110L) is in the off state the first transistor (101) is subjected to a drain source voltage corresponding to the difference between the bias voltage (Vb) and the voltage of the low voltage rail (V-), and the second transistor (102) is subjected to a drain source voltage corresponding to the difference between the voltage of the high voltage rail (V+) and the bias voltage (Vb).

3. The inverter of claim 1 or 2, wherein the bias voltage (Vb) is provided from the dc capacitor bank (202, 201).

4. The inverter (200) of claim 3, wherein the bias voltage (Vb) is provided from the midpoint node (M) at a midpoint of the dc capacitor bank (202, 201) such that the midpoint node (M) is in use clamped to half the voltage difference between the high voltage rail (V+) and the low voltage rail (V-).

5. The inverter (200) of any preceding claim, wherein the bias voltage (Vb) is provided via a gate protection diode (103) that is arranged between the gate and source of the second transistor (102).

6. The inverter (200) of claim 5, wherein the bias voltage (Vb) is provided via a gate protection diode (103) that is arranged between the gate and source of the second transistor (102), with the bias voltage (Vb) comprising the voltage at the midpoint node (M) less the diode voltage drop (Vd) of the gate protection diode (103).

7. The inverter (200) of any preceding claim, comprising a bootstrap unit (330) for at least one of the upper and lower switching circuits (110U, 100L), the bootstrap unit (330) arranged to stabilise the arrangement of the first and second transistors (101, 102) in the associated switching circuit in an initial off state before switching operation of the upper and lower switching circuits (110U, 110L) starts.

8. The inverter (200) of claim 7, wherein the bootstrap unit (330) is arranged to stabilise the arrangement of the first and second transistors (101, 102) in the associated switching circuit (110U, 110L) in an initial off state while the other switching circuit (110L, 110U) is driven in an initial on state before switching operation of the upper and lower switching circuits (110U, 110L) starts.

9. The inverter (200) of claim 7 or 8, wherein the bootstrap unit (330) comprises a capacitor (331) arranged to stabilise the bias voltage between the source of the first transistor (101) and the gate of the second transistor (102) in the associated switching circuit (110U, 110L).

10. The inverter (200) of any one of claims 7, 8 or 9, wherein the bootstrap unit (330) comprises a capacitor (331) charged from the halfway node (N).

11. The inverter (200) of any one of claims 7 through 10, wherein the bootstrap unit (330) is provided for the upper switching circuit (110U).

12. The inverter (200) of any preceding claim, wherein the upper and/or lower switching circuit(s) (110U, 100L) comprise(s) a capacitor (104) arranged between the source of the first transistor (101) and gate of the second transistor (102), the capacitance of which is matched to the parasitic capacitances in the switching circuit (110U, 110L) to speed up operation of the second transistor (102) by delivering/receiving charge to/from the gate of the second transistor (102) during switching of the second transistor (102).

13. The inverter (200) of any preceding claim, wherein the upper and/or lower switching circuit(s) (100U, 100L) comprise(s) a first transistor (101) and a second transistor (102) which are nominally identical to one another.

14. The inverter (200) of any preceding claim, wherein the upper and/or lower switching circuit(s) (100U, 100L) comprise(s) a first transistor (101) and a second transistor (102) which are both normally-off HEMT devices.

15. The inverter (200) of any preceding claim, comprising part of an ac motor drive.
